(19) Europäisches Patentamt
European Patent Office
Office européen des brevets

(11) EP 4 083 048 A2

(12) EUROPEAN PATENT APPLICATION
published in accordance with Art. 153(4) EPC

(43) Date of publication:
02.11.2022 Bulletin 2022/44

(51) International Patent Classification (IPC):
*C07F 13/00* (2006.01)   *H01L 51/42* (2006.01)

(21) Application number: 20906729.7

(22) Date of filing: 24.12.2020

(52) Cooperative Patent Classification (CPC):
**C07F 13/00; H01L 51/42;** Y02E 10/549; Y02P 70/50

(86) International application number:
PCT/KR2020/019067

(87) International publication number:
WO 2021/133085 (01.07.2021 Gazette 2021/26)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 27.12.2019 KR 20190176037

(71) Applicant: Kyungpook National University Industry-Academic Cooperation Foundation
Daegu 41566 (KR)

(72) Inventors:
• JOO, Jin
  Daegu 42113 (KR)
• LEE, Sang Wook
  Daegu 41022 (KR)
• MIN, Gyeong Uk
  Daegu 41214 (KR)
• YUN, Yeong Hun
  Daegu 41569 (KR)

(74) Representative: Schmid, Nils T.F.
Boehmert & Boehmert
Anwaltspartnerschaft mbB
Pettenkoferstrasse 22
80336 München (DE)

(54) **PREPARATION METHOD FOR ORGANIC HALIDE FOR PREPARATION OF PEROVSKITE, PEROVSKITE PREPARED THEREBY, AND SOLAR CELL**

(57) The present invention relates to a preparation method for an organic halide used for preparation of perovskite, perovskite prepared thereby, and a solar cell. According to the present invention, an organic halide used for perovskite may be prepared by an ion-exchange method using alkali metal iodide or alkali metal bromide.

FIG. 1B

## Description

### FIELD

The present disclosure relates to a method for preparing an organic halide used for preparing a perovskite, a perovskite prepared thereby, and a solar cell. Specifically, the present disclosure relates to the above preparation method characterized by using an alkali metal iodide or bromide, a perovskite prepared thereby, and a solar cell.

### DESCRIPTION OF RELATED ART

A perovskite solar cell acts as a potential alternative to a crystalline silicon solar cell which currently accounts for 93% of a global solar cell market and thus has developed very rapidly over the past few years. An organic halide such as methylammonium halide (MAX, X=I or Br) and formamidinium halide (FAX) is an important material used for a photoactive layer of an organometallic trihalide in the perovskite solar cell. The perovskite solar cell has excellent optical and electrical properties due to high light absorption efficiency, long charge carrier lifetime, and a long diffusion distance of charge carriers. Thus, power conversion efficiency of the perovskite solar cell has achieved significant improvement from 3.8% to 25.2% for recent several years. Whereas a conventional thin film solar cell (e.g., based on Cu(In,Ga)(S,Se) and CdTe) is manufactured using sputtering or vapor deposition under vacuum, a perovskite photoactive layer is formed by a simple spin coating method using $PbX_2$ precursor and organic halide in a solution state. Due to characteristics of the solution process, an organometallic trihalide-based perovskite solar cell is more economical and competitive than a thin-film solar cell that relies on vacuum technology.

Among organic halides, methylammonium iodide (MAX, X=I) has high reproducibility. A $MAPbI_3$-based perovskite solar cell prepared using the methylammonium iodide has excellent photo-electric properties, and power conversion efficiency of about 21.2%. Therefore, the methylammonium iodide is an important precursor. Further, when a MA portion thereof is replaced with FA, a light absorption wavelength of the solar cell using FAX may extend to a larger wavelength region, and thus an absorption range of a solar spectrum thereof may be wider, so that a power output of the solar cell is improved. However, most of synthetic procedures of MAX and FAX involve use of toxic and expensive hydrogen halide precursor. For example, MAI is synthesized via acid-base reaction between aqueous methylamine and HI. In a similar manner, FAI is prepared via reaction between formamidinium acetate (FAAc) and HI. Although a method for preparing the organic iodide has relatively high yield and reproducibility, synthesis thereof requires use of HI, such that very careful handling of a reaction mixture is required during the synthesis. HI is the strongest acid (pKa of HI = -9.3) among hydrogen halides. When HI is exposed to air, HI is easily oxidized due to oxygen and is converted to $I_2$. Therefore, concentrations below 0.1 ppm and 0.2 ppm of HI and HBr, respectively are recommended according to 2006 air pollution standards set by UK experts. Further, the perovskite solar cell has a low production cost. However, excessive use of HI to increase a reaction yield in the reaction of MA or FA with HI increases a production cost, thereby lowering economic feasibility of the perovskite solar cell.

From the point of view of the preparation process, special attention is required in a process of removing water and unreacted HI or HBr under reduced pressure in order to separate a product from a toxic aqueous mixture. In conclusion, developing an economical and environmentally friendly method for synthesizing the organic halide is important for industrial production of the perovskite solar cell. An approach to improve stability and power conversion efficiency of the perovskite solar cell has been extensively studied in recent years. However, few studies and patents addressing the issue of the organic halide precursor preparation have been reported.

### DISCLOSURE

### TECHNICAL PURPOSES

One purpose of the present disclosure is to provide a method for preparing an organic halide used for preparing a perovskite, without using conventional HI or HBr which is toxic.

Another purpose of the present disclosure is to provide a perovskite prepared using the organic halide prepared using the above preparation method as a precursor.

Another purpose of the present disclosure is to provide a solar cell including the perovskite.

### TECHNICAL SOLUTIONS

A first aspect of the present disclosure provides a method for preparing an organic halide used for preparing a perovskite, the method comprising: a step (a) of reacting methylammonium chloride or formamidinium chloride with alkali metal iodide or alkali metal bromide.

A second aspect of the present disclosure provides a perovskite prepared using the organic halide prepared by the above method as a precursor.

A third aspect of the present disclosure provides a solar cell comprising: a first electrode; a second electrode opposite to the first electrode; and a photoactive layer disposed at least partially between the first electrode and the second electrode, wherein the photoactive layer includes a perovskite prepared using the organic halide prepared by the above method as a precursor.

**TECHNICAL EFFECTS**

In accordance with the present disclosure, alkali metal iodide or alkali metal bromide instead of conventional toxic HI or HBr is used as a halide source, thereby preparing a perovskite precursor in an easy and environmentally friendly way. According to the prior art, when strong acids such as HI or HBr are used, they are oxidized via reacting with oxygen when stored in air for a long time. Thus, a special storage condition thereof is required. This is not suitable for mass production. Further, HI or HBr may be used in drug preparation and may belong to a List I compound of the United States Drug Enforcement Administration (DEA) and thus is subject to surveillance. In addition, an additional cooling system is required due to the strong exothermic nature of the acid-base reaction. In contrast, according to the present disclosure, because such strong acids are not used, preparation equipment may be simplified, a cost of a raw material may be lower and waste disposal may be easy, thereby allowing design of safer and simpler mass production. In addition, the preparation method according to the present disclosure has a high production yield. Accordingly, the method for preparing the organic halide according to the present disclosure has significantly higher economic feasibility than that of the method of the prior art.

**BRIEF DESCRIPTION OF DRAWINGS**

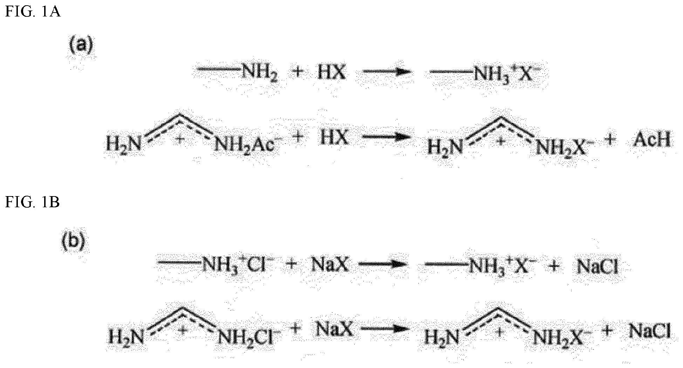

FIG. 1A is a schematic diagram of a method for preparing an organic halide used for a perovskite according to a prior art, and FIG. 1B is a schematic diagram of a method for preparing an organic halide used for a perovskite according to one embodiment of the present disclosure.

FIG. 2 shows a yield of each of four organic halides prepared under a reflux condition using ethanol (EtOH) or water as a solvent according to one Experimental Example of the present disclosure.

FIG. 3 shows a yield of each of four organic halides prepared at room temperature using ethanol (EtOH) or water as a solvent according to one Experimental Example of the present disclosure.

FIG. 4 shows hydrogen nuclear magnetic resonance ($^1$H NMR) spectra of samples prepared according to one Experimental Example of the present disclosure.

FIG. 5 shows X-ray diffraction patterns of samples prepared according to one Experimental Example of the present disclosure.

FIG. 6 is a table showing X-ray fluorescence analysis (XRF) based elemental analysis results of samples prepared according to one Experimental Example of the present disclosure, and a number in ( )[a] indicates an analysis results after recrystallization of each of the prepared samples.

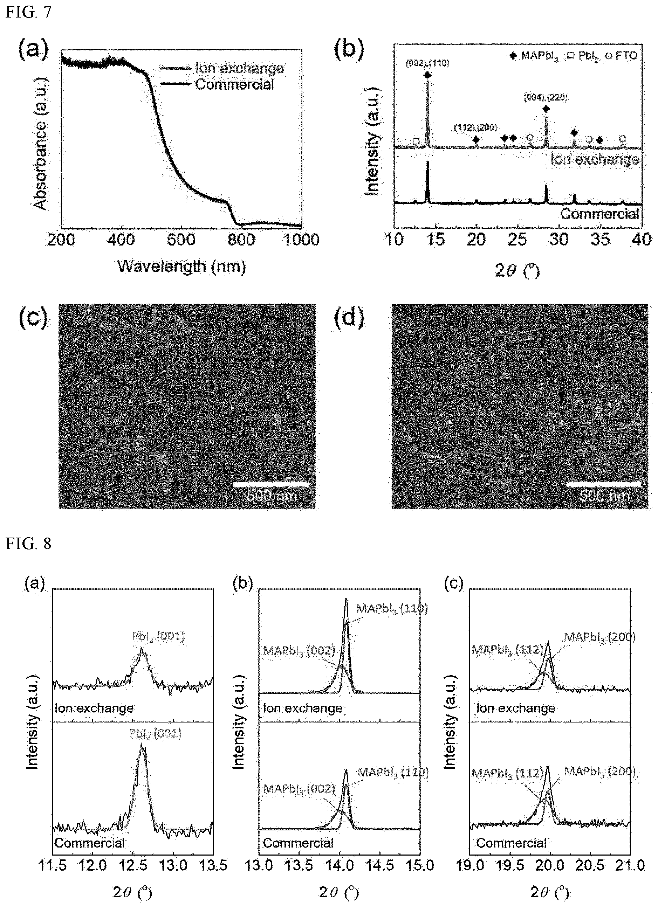

(a) in FIG. 7 shows an UV-Vis absorption spectrum of a perovskite film prepared using each of an organic halide prepared according to one Experimental Example of the present disclosure and a commercially available organic halide. (b) in FIG. 7 shows a XRD pattern of a perovskite film prepared using each of an organic halide prepared according to one Experimental Example of the present disclosure and a commercially available organic halide. Further, FIG. 7C and FIG. 7D are top views of SEM images of perovskite films prepared respectively using an organic halide prepared according to one Experimental Example of the present disclosure and a commercially available organic halide, respectively.

(a) to (c) in FIG. 8 are enlarged views of XRD patterns of (b) in FIG. 7 of perovskite films prepared using organic halides prepared according to one Experimental Example of the present disclosure and commercially available organic halides.

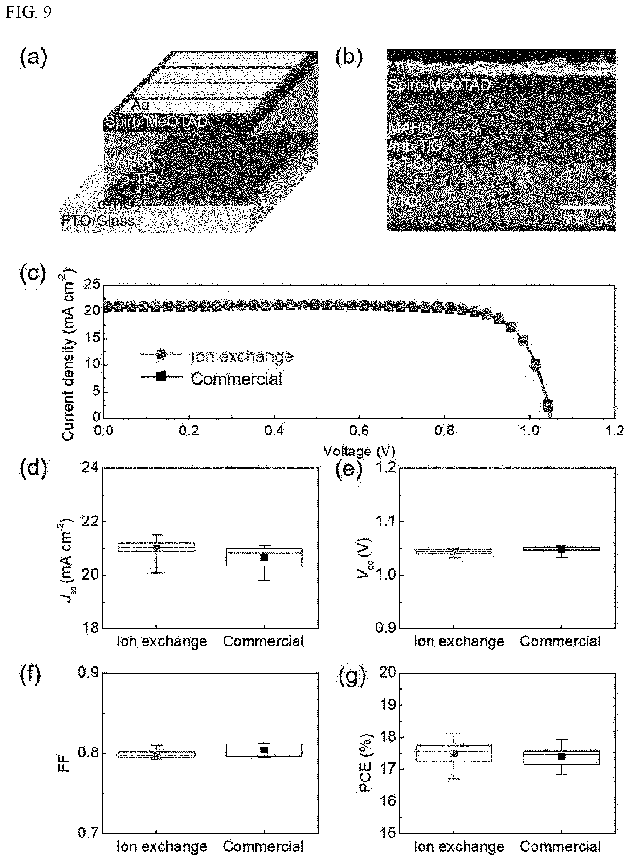

(a) in FIG. 9 shows a structure of a mesoporous perovskite solar cell (PSC) prepared in one Experimental Example of the present disclosure, and (b) in FIG. 9 shows a cross-sectional SEM image of the solar cell. Further, (c) FIG. 9 shows a current density-voltage curve (J-V curve) of each of PSC prepared using an organic halide prepared according to one Experimental Example of the present disclosure and PSC prepared using a commercially available organic halide. (d) FIG. 9 shows a short circuit current density (Jsc) of each of PSC prepared using an organic halide prepared according to one Experimental Example of the present disclosure and PSC prepared using a commercially available organic halide. (e) FIG. 9 shows an open circuit voltage (Voc) of each of PSC prepared using an organic halide prepared according to one Experimental Example of the present disclosure and PSC prepared using a commercially available organic halide. (f) FIG. 9 shows a charge factor (FF) of each of PSC prepared using an organic halide prepared according to one Experimental Example of the present disclosure and PSC prepared using a commercially available organic halide. (g) FIG. 9 shows power conversion efficiency (PCE) of each of PSC prepared using an organic halide prepared according to one Experimental Example of the present disclosure and PSC prepared using a commercially available organic halide.

## DETAILED DESCRIPTIONS

Hereinafter, terminologies as used herein are only used to describe a specific implementation and are not intended to limit the present disclosure. Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "comprises", "comprising", "includes", and "including" when used in this specification, specify the presence of the stated features, integers, operations, elements, and/or components, but do not preclude the presence or addition of one or more other features, integers, operations, elements, components, and/or portions thereof.

As used herein, a "perovskite" refers to an organic/inorganic halide material in which cations (R and M) and an anion (X) constitute a chemical formula of $RMX_3$, and which has the same crystal structure as that of $CaTiO_3$ as a first perovskite-type material.

As used herein, a "perovskite solar cell" refers to a solar cell including an organic/inorganic halide material having a perovskite crystal structure.

## Method for preparing organic halide used for preparing perovskite

According to a first aspect of the present disclosure, a method for preparing an organic halide used for preparing a perovskite in accordance with the present disclosure a step (a) of reacting methylammonium chloride or formamidinium chloride with alkali metal iodide or alkali metal bromide.

In the alkali metal iodide or alkali metal bromide of the present disclosure, the alkali metal is not particularly limited as long as it reacts with the methylammonium chloride or formamidinium chloride, and may specifically be lithium, sodium, potassium, or the like. According to one implementation of the present disclosure, the alkali metal iodide or alkali metal bromide may be sodium iodide (NaI) or sodium bromide (NaBr). The NaI and NaBr may be useful in that they have high solubility in solvents such as water and alcohol.

The organic halide in the preparation method according to the present disclosure may be methylammonium iodide (MAI), methylammonium bromide (MABr), formamidinium iodide (FAI), or formamidinium bromide (FABr).

According to one implementation of the present disclosure, the reaction step (a) may be performed based on an ion exchange reaction in a solvent. The solvent may be water or alcohol, wherein the alcohol may be a monohydric or dihydric alcohol having 1 to 5 carbon atoms, specifically, a monohydric alcohol having 1 to 5 carbon atoms, more specifically, ethanol.

Further, according to one implementation of the present disclosure, the reaction step (a) may be performed in a solvent at room temperature or under reflux. A temperature suitable for the reflux may be appropriately determined depending on a type of the solvent as used. For example, the temperature may be 100°C when water is used as a solvent, or may be 78°C when ethanol is used as a solvent. A reaction time may be determined based on a reaction rate and a target yield. For example, the reaction may be performed for a duration from 1 minute to 24 hours under stirring. However, the present disclosure is not limited thereto. The reaction may be performed for a time duration of 24 hours or larger.

Further, according to another implementation of the present disclosure, the method may further include, after the reaction step (a), a step (b) of filtering a product of the reaction step (a), and a step (c) of removing the solvent therefrom. NaCl as a reaction by-product may be removed therefrom in the filtration step (b). Further, in the solvent removal step (c), when the solvent is water, the water may be first removed in the step (c), then the product may be dissolved in alcohol and then the filtration step (b) may be performed. In another example, when the solvent is alcohol, the filtration step (b) may be performed first, and then the step (c) may be performed wherein the step (c) may be performed by evaporating the alcohol.

According to another implementation of the present disclosure, the method may further include a step (d) of performing recrystallization of the organic halide produced in the reaction step (a) and removing alkali metal chloride therefrom. The organic halide produced in the step (a) inevitably contains ionic salt impurities (e.g., alkali metal chloride, alkali metal iodide, methylammonium chloride, or formamidinium chloride) due to the execution of the ion exchange method. Therefore, after performing the step (a), when necessary, the steps (b) and/or (c) may be further executed, and then the product may be subjected to recrystallization to further remove the ionic salt impurities, specifically, alkali metal chloride, etc.

## Perovskite prepared from organic halide in accordance with the present disclosure

According to a second aspect of the present disclosure, a perovskite prepared using the organic halide prepared by the method for preparing the organic halide as described above as a precursor is provided.

The perovskite has an $RMX_3$ structure. According to the present disclosure, R may be a methylammonium cation or formamidinium cation, X may be an iodide anion or a bromide anion, and M may be a divalent metal cation selected from a group consisting of $Pb^{2+}$, $Sn^{2+}$, $Ge^{2+}$, and combinations thereof.

## Solar cell

According to a third aspect of the present disclosure, a solar cell is provided which includes first and second electrodes opposite to each other, and a photoactive layer disposed at least partially between the first electrode and the second electrode, wherein the photoactive layer includes the perovskite obtained using the organic halide prepared by the preparation method of the organic halide as a precursor.

According to one implementation of the present disclosure, the perovskite may be obtained by reacting the organic halide as described above with a compound of a chemical formula $MX_2$. In this regard, X may be an iodide anion or a bromide anion, and M may be a divalent metal cation selected from the group consisting of $Pb^{2+}$, $Sn^{2+}$, $Ge^{2+}$, and combinations thereof. The photoactive layer including the perovskite may be prepared simply via, for example, spin coating using the compound of the chemical formula $MX_2$ and the organic halide in a solution state.

According to one implementation of the present disclosure, the first electrode may be one of an anode and a cathode, and the second electrode may be the other of the anode and the cathode. According to another implementation of the present disclosure, either or both of the first electrode and the second electrode may be coated on a substrate. According to still another implementation of the present disclosure, the solar cell may further include an electron transport layer and a hole transport layer between the first electrode and the second electrode. Further, the photoactive layer of the solar cell may further include a photoactive material, for example, a semiconductor material other than the perovskite material. Further, the photoactive layer may include both a perovskite layer and a layer including a photoactive material other than the perovskite, for example a semiconductor layer.

Hereinafter, the present disclosure will be described in more detail with reference to Examples.

## [Examples]

## Material as used

following materials were used as purchased without further purification: NaI (99.5%, Wako product), NaBr (99.5%, Junsei product), methylammonium chloride (MACl, 98.0%, Junsei product), FAAc (98%, TCI product), ethanol (EtOH, 99.5%, Samchun Chemical product), diethyl ether (Et$_2$O, ≥99.7%, Sigma-Aldrich product), methylamine solution (40 wt% in water, TCI product), hydroiodic acid (HI, 57 wt% in water, Sigma-Aldrich product), hydrobromic acid (HBr, 48 wt% in water, Sigma-Aldrich product), titanium diisopropoxide bis(acetylacetonate) (75 wt% in isopropanol, Sigma-Aldrich product), 1-butanol (99%, Sigma) -Aldrich product), terpineol (anhydrous, Sigma-Aldrich product), PbI$_2$ (99.9%, TCI product), N,N-dimethylformamide (DMF, 99.8%, Sigma-Aldrich product), dimethyl sulfoxide (DMSO, ≥99.9%, Sigma-Aldrich product), acetonitrile (anhydrous, 99.8%, Sigma-Aldrich product), 2,2',7,7'-tetrakis(N,N-di-p-methoxyphenylamine)-9,9'-spirobifluorene(spiro-MeOTAD, >99.5%, Luminescence Technology Corp. product), bis(trifluoromethane)sulfonamide lithium salt (Li-TFSI, 99%, Alfa Aesar product), tris(2-(1H-pyrazol-1-yl)-4-tert-butylpyridine) cobalt(III) tri[bis(trifluoromethane)sulfonamide] (Co-TFSI, FK209, Greatcell Solar product), and 4-tert-butylpyridine (96%, Sigma-Aldrich product). The formamidinium chloride (FACl) was prepared using a conventional method, that is, based on a reaction of FAAc and HCl solution (See [I. Levchuk, A. Osvet, X. Tang, M. Brandl, J.D. Perea, F. Hoegl, G.J.Matt, R. Hock, M. Batentschuk andCJ.Brabec, Nano Lett. 2017, 17, 2765-2770])

## 1. Experimental Examples

## 1-(1). Synthesis of MAX and FAX (X = Br and I) organic halides

### 1-(1)-①. Synthesis of MAI

Organic halides of MAX and FAX were synthesized by reacting NaX (X = Br or I) with MACl or FACl in water (or EtOH) at a suitable temperature. For the synthesis of MAI via ion exchange reaction, each of 20 mmol (3.0 g) of NaI and 20 mmol (1.35 g) of MACl was individually dissolved in 100 mL of deionized water to produce each mixed solution and then both the two mixed solutions were input into a 500 mL round bottom flask at room temperature to produce a mixed aqueous solution. A reaction of the mixed aqueous solution was carried out for 3 hours under reflux (or at room temperature) while vigorously stirring the mixed aqueous solution under the reflux condition of 100°C or higher (about 78°C when EtOH was used). After completion of the reaction, water was removed from a reaction mixture under vacuum. Thus, yellowish white powders were produced, which were dispersed in EtOH (or isopropanol) and then NaCl was removed therefrom via filtration (when isopropanol was used, a larger amount thereof than an amount of EtOH was required, but an amount of impurity NaCl was greatly reduced). EtOH (or isopropanol) was evaporated under vacuum. A thus-obtained product was washed several times with $Et_2O$, and a residual solvent was evaporated to obtain MAI of a high purity. When EtOH was used instead of water as solvent, MAI was obtained immediately after MAI filtration and subsequent EtOH evaporation and washing with $Et_2O$. When the reaction was carried out using EtOH as a solvent, a temperature was lowered to room temperature under a reflux condition, and then NaCl was removed via filtration and the solvent was removed therefrom to obtain MAI.

### 1-(1)-②. Synthesis of MABr, FABr, and FAI

Further organic halides other than MAI were respectively prepared using further precursors other than that used for the synthesis of MAI while the same synthetic conditions as those used for the synthesis of MAI were maintained: MABr was prepared using MACl and NaBr; FABr was prepared using FACl and NaBr; and FAI was prepared using FACl and NaI.

### 1-(1)-③. Synthesis of further MAI

Further MAI was synthesized under the same conditions as those used for the synthesis of MAI of 1-(1)-① except that 7.36 g of MACl and 16.34 g of NaI were dissolved in 100 mL of EtOH.

**1-(1)-④. Synthesis of further FAI**

Further FAI was synthesized under the same conditions as those used for the synthesis of MAI in 1-(1)-① except that 14.92 g of FACl and 27.79 g of NaI were dissolved in 100 mL of EtOH.

## 1-(2). Preparation of perovskite solar cell (PSC)

For comparison between performances of solar cells, a solar cell was manufactured using MAI (abbreviated as IE-MAI in the solar cell characterization) prepared using the ion exchange method according to 1-(1)-①, and a solar cell was manufactured using a commercially available MAI (≥99.5 %, Xi'an Polymer Light Technology Corp. product) (abbreviated as CO-MAI in the solar cell characterization). Both IE-MAI and CO-MAI used for the solar cells were obtained based on recrystallization from a mixed solvent of $Et_2O$ and EtOH.

All solar cells were manufactured according to a conventional method. A fluorine-doped tin oxide (FTO) substrate of $2 \times 2$ cm$^2$ (Pilkington TEC8) was cleaned in an ultrasonic bath for 15 minutes using sequentially acetone, deionized water and isopropyl alcohol. The cleaned substrate was dried under a $N_2$ gas stream. First, a 1-butanol solution in which 0.15 M titanium diisopropoxide bis(acetylacetonate) was dissolved was spin-coated on the substate at 3000 rpm for 20 seconds to form a $TiO_2$ dense layer (c-$TiO_2$) on the substate. c-$TiO_2$/FTO was baked at 125°C for 5 minutes, then immersed in a 0.05 M $TiCl_4$ solution at 70°C for 30 minutes and rinsed with deionized water and isopropyl alcohol. Then, diluted $TiO_2$ paste (SC-HT040, SCHARECHEM Co. product) composed of $TiO_2$ nanoparticles (about 50 nm average diameter) was spin-coated thereon to form a mesoporous $TiO_2$ (mp-$TiO_2$) layer thereon. The $TiO_2$ paste was diluted in a mixed solvent (1-propanol to terpineol in a 3.5:1 ratio) at a paste to solvent ratio of 1:3.5. The mp-$TiO_2$ layer was then baked at 125°C for 5 minutes and annealed at 500°C for 30 minutes.

The $MAPbI_3$ film was formed via a conventional solvent engineering method. A precursor solution was spin-coated at 4000 rpm for 20 seconds such that a $MAPbI_3$ film was coated on the obtained mp-$TiO_2$/c-$TiO_2$/FTO/glass substrate. The precursor solution was prepared by dissolving 52 wt% of the precursor, that is, $PbI_2$ and target MAI (IE-MAI or CO-MAI) in a mixed solvent of anhydrous DMF and DMSO at a volume ratio of 7.33:1. Then, 0.5 mL of $Et_2O$ was

injected onto the substrate during the spin coating. Next, the substrate was sequentially annealed at 65°C (1 min) and 130°C (10 min). A hole transport layer was spin coated on the perovskite layer at 3000 rpm for 30 seconds. A hole transport material precursor solution was prepared by sequentially adding 18 $\mu$L of Li-TFSI solution and 14.7 mg of Co-TFSI into 1 mL of spiro-MeOTAD solution. The Li-TFSI solution was prepared by dissolving 566 mg of Li-TSFI in 1 mL of acetonitrile. The spiro-MeOTAD solution was prepared by sequentially dissolving 80 mg of spiro-MeOTAD and 32 $\mu$L of 4-tert-butylpyridine in 1 mL of chlorobenzene. Finally, an Au electrode was deposited on the hole transport layer via a thermal evaporation method at a deposition rate of 1 Ås$^{-1}$.

## 2. Characterization

$^1$H nuclear magnetic resonance (NMR) spectra were obtained using a Bruker AVANCE III 500 spectrometer. X-ray diffraction (XRD) patterns were recorded on a PANalytical X'Pert PRO MPD equipped with a Cu K$\alpha$ radiation source ($\lambda$=1.5405 Å), with a step size of 0.016°. Elemental analysis was performed using a wavelength dispersive X-ray fluorescence (WD-XRF) spectrometer (Bruker S8 Tiger). To investigate the performances of the perovskite solar cells, a solar simulator (Newport Oriel Solar 3A Class, 94023A) with a source meter (Keithley 2450) was used. The solar simulator was calibrated to irradiate AM 1.5G (100 mAcm-2) using a standard Si reference cell (Newport, 91150V). A current density-voltage (J-V) curve was recorded at a forward bias (0V to 1.2V) and a reverse bias (1.2V to 0V) at a scan rate of 30 mVs$^{-1}$ or 100 mVs$^{-1}$. An active area of each solar cell was 0.107 cm$^2$.

## Experiment results

### 2-(1). Synthesis of organic halide using ion exchange method

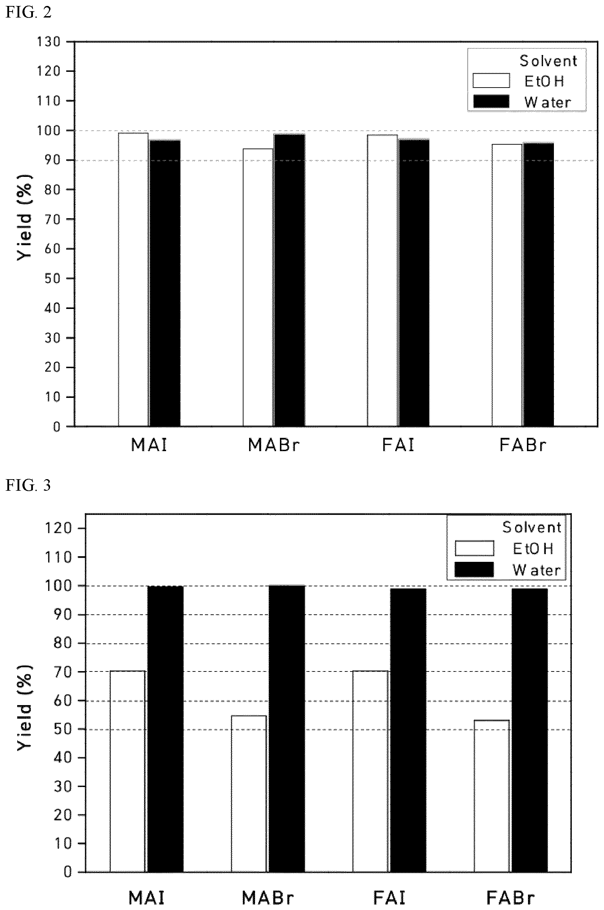

NaI and NaBr among the various alkali metal halides are highly soluble in both water and EtOH used as solvents in this experiment (about 46 g NaI and about 2.32 g NaBr per 100 g EtOH). Thus, NaI and NaBr are most suitable as an ion exchange reactant with MACl or FACl. On the contrary, low solubility of a reaction by-product NaCl (about 0.065 g per 100 g EtOH) allows the MAI to be separated from a reaction mixture via simple filtration. FIG. 2 shows a yield of each of four organic halides (MAI, MABr, FAI, and FABr) prepared under the reflux condition according to 1-(1)-① and 1-(1)-① as described above. Further, although not shown in FIG. 2, the yields of the MAI prepared according to 1-(1)-③ and the FAI prepared according to 1-(1)-④ are 98% and 94.2%, respectively. It may be identified that, in all cases 1-(1)-① to 1-(1)-④, excellent yields are achieved using a simple ion exchange reaction (the yields are similar to that achieved using a conventional procedure using hydrogen halide).

With regard to a reaction heat, the ion exchange method allows design of safer and simpler mass production. A HX path of an organic halide synthesis according to the prior art requires an additional cooling system due to strong exothermic nature of an acid-base reaction. In contrast, only a very slight increase in temperature is observed in the ion exchange reaction. This result indicates that the ion exchange method is very applicable to the mass production of the organic halide precursor. Further, according to the present disclosure, corrosivity of solid-state MACl and NaX is negligible. Thus, a special storage condition for these reactants is not required. This may act as a significant advantage in the mass production, compared to the HI path of the prior art.

Replacing water with EtOH as solvent allows the water removal step to be omitted. This simplifies the synthesis method, and allows the final organic halide product to be isolated directly from the reaction mixture via filtration, thereby reducing energy consumption in mass production. However, when the ion exchange was performed in an EtOH solvent at room temperature, the reaction yield was substantially reduced compared to that when water was used as the solvent (see FIG. 3). In one example, referring to FIG. 3, the reaction yield clearly depended on characteristics of not the cation but the anion of the product. That is, the reaction rates of MAI and FAI were much higher than those of MABr and FABr, and the final yields of MAI and FAI at room temperature were about 70%, whereas the final yields of MABr and FABr at room temperature were about 50%. In one example, the synthesis temperature strongly affects the reaction kinetics when EtOH is used as a solvent. When EtOH as a solvent is replaced with water, almost 100% reaction yield is achieved at room temperature regardless of the characteristics of the halide anion (See FIG. 3).

### 2-(2). Characterization of organic halide synthesized using ion exchange method

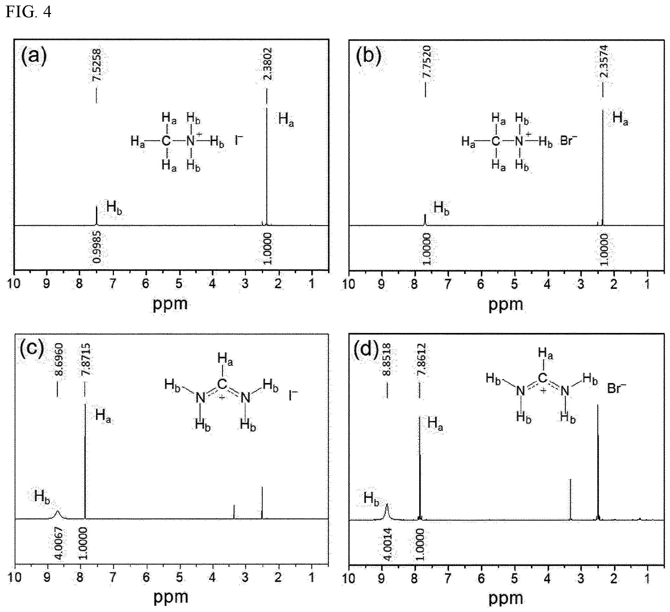

A purity of each of the organic halide samples synthesized using the ion exchange according to 1-(1)-① and 1-(1)-② as described above was checked using $^1$H NMR spectroscopy (FIG. 4). In all spectra, pure MAX and FAX free of the organic contaminant (e.g., -NH$_2$ of methylamine at 2.0 ppm) were observed.

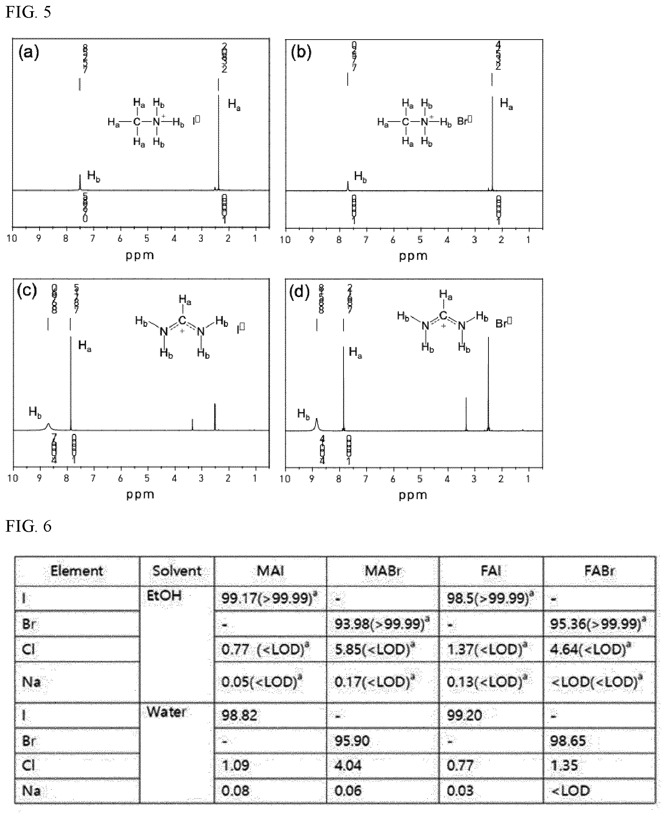

To further check the product purity, X-ray diffraction patterns of MAI, MABr, FAI, and FABr synthesized according to 1-(1)-① and 1-(1)-② as described above were obtained (FIG. 5). As may be identified from FIG. 5, all of diffraction peaks of the samples as prepared according to the present disclosure were in good agreement with diffraction peaks of reference MAX and FAX. However, in the ion exchange method, ionic salt impurities such as NaCl and NaI was inevitably produced. Therefore, elemental analysis of the sample prepared using the ion exchange reaction was performed using XRF and based on impurity ions not detected in $^1$H NMR analysis. Results are shown in FIG. 6. For example, small amounts of Na and Cl were detected in the as-prepared samples, while Na and Cl were not detected in all of MAI, MABr, FAI, and FABr after recrystallization thereof using methanol.

### 2-(3). Characterization of perovskite film

A methylammonium lead triiodide ($CH_3NH_3PbI_3$, $MAPbI_3$) perovskite thin film was prepared using the IE-MAI synthesized according to 1-(1)-① of the present disclosure, and optical, structural, and morphological properties thereof were investigated. For comparison, a $MAPbI_3$ film using commercial MAI instead of IE-MAI according to the present disclosure was also prepared using the same preparation method.

FIG. 7A shows the UV-Vis absorption spectrum of the perovskite film. There was no difference between optical absorption properties of perovskite thin films of different types of MAI. Both films had exactly the same absorbance and absorption edge over an entire wavelength range. Since thicknesses of the two $MAPbI_3$ films are equal to each other, absorption coefficient $\alpha$ values of the $MAPbI_3$ materials thereof ($\alpha = 2.303 A/t$, where A is absorbance and t is a thickness) are equal to each other even when the MAI sources thereof are different from each other.

FIG. 7B shows the XRD pattern of the $MAPbI_3$ film. A diffraction pattern of tetragonal perovskite (I4/mcm) of each of both films is clearly observed. This indicates that a matrix of each of both films is $MAPbI_3$. A small peak at 12.7° is derived from a small amount of $PbI_2$, which is a common residue in a solvent engineering method. It is noteworthy that peak intensities of $PbI_2$ of IE-MAPbI3 and CO-MAPbI3 are different from each other (See FIG. 8a).

A comparison result based on a ratio between an intensity of the $MAPbI_3$ (110) peak and an intensity of the $PbI_2$ peak at 12.7° (the ratio are 0.04 and 0.13 for IE-$MAPbI_3$ and CO-$MAPbI_3$, respectively) indicates that a relative amount of $PbI_2$ in IE-$MAPbI_3$ is smaller than 1/3 of a relative amount of $PbI_2$ in CO-$MAPbI_3$. This difference in the amount of $PbI_2$ seems to be due to a difference in an amount of chlorine in the MAI precursor. According to XRF analysis, 0.12% chlorine was detected in IE-MAI, whereas no chlorine was detected in CO-MAI. It has been reported that chlorine promotes $MAPbI_3$ formation, thereby allowing a smaller amount of $PbI_2$ to be extracted from the perovskite layer. When $PbI_2$ is present, it adversely affects the efficiency of the solar cell. Thus, a small amount of $PbI_2$ is preferable in a state of the solar cell solar cell. Therefore, because the intensity of the $PbI_2$ peak of IE-$MAPbI_3$ is relatively weaker in the XRD peak intensity data as described above, the amount of $PbI_2$ present in the perovskite layer is smaller. Therefore, it may be identified that the perovskite layer using IE-$MAPbI_3$ may provide relatively better performance than the perovskite layer using CO-$MAPbI_3$ may.

Further major differences between the XRD patterns of IE-$MAPbI_3$ and CO-$MAPbI_3$ are a full width at half maximum (FWHM) and a peak area of the $MAPbI_3$ (110) peak. Gaussian fitting results measured from the XRD peaks are summarized in Table 1 below. The (110) peak areas obtained based on the Gaussian fitting are 0.67 and 0.45 for IE-$MAPbI_3$ and CO-$MAPbI_3$, respectively (see FIG. 8 and Table 1). This indicates higher crystallinity of IE-$MAPbI_3$. Further, the FWHMs of the $MAPbI_3$ (110) peak were found to be 13.33 and 12.14 in the patterns of IE-$MAPbI_3$ and CO-$MAPbI_3$, respectively. This indicates that a crystallite size of IE-$MAPbI_3$ is larger by 10% than that of CO-$MAPbI_3$, based on an estimating result according to the Scherrer equation [$B = K\lambda/Lcos\theta$, where B is the FWHM, K is a shape factor (close to 1 in this case), $\lambda$ is a X-ray wavelength, $\theta$ is a Bragg angle, and L is an average particle size]

[Table 1]

| Sample | Peak | Area | FWHM | 1/FWHM |
|---|---|---|---|---|
| IE-MAPbI$_3$ | PbI$_2$ | 0.0278 | 0.2091 | 4.7815 |
| | MAPbI$_3$ (002) | 0.6683 | 0.1978 | 5.0554 |
| | MAPbI$_3$ (110) | 0.6717 | 0.0750 | 13.3333 |
| | MAPbI$_3$ (112) | 0.0294 | 0.2153 | 4.6449 |
| | MAPbI$_3$ (200) | 0.0257 | 0.1027 | 9.7352 |
| CO-MAPbI$_3$ | PbI$_2$ | 0.0586 | 0.1816 | 5.5066 |
| | MAPbI$_3$ (002) | 0.5084 | 0.2210 | 4.5255 |
| | MAPbI$_3$ (110) | 0.4546 | 0.0823 | 12.1448 |
| | MAPbI$_3$ (112) | 0.0460 | 0.2310 | 4.3292 |
| | MAPbI$_3$ (200) | 0.0236 | 0.0886 | 11.2905 |

Further, it was identified from the SEM image that a particle size of the IE-MAPbI$_3$ film was slightly larger. (c) and (d) in FIG. 7 show top views of SEM images of the IE-MAPbI$_3$ film and the CO-MAPbI$_3$ film, respectively. The particle sizes of IE-MAPbI$_3$ and CO-MAPbI$_3$ were 343 nm and 304 nm, respectively, as measured by an average particle intercept method. The measurements were consistent with the results of XRD analysis. The high crystallinity and the larger particle size may be due to the presence of chlorine in the IE-MAI precursor. It is reported that incorporation of chlorine ions promotes crystallization of perovskite and accelerates grain growth.

### 2-(4). Characterization of perovskite solar cell (PCS)

In order to evaluate the MAPbI$_3$ film using the IE-MAI as a base, a perovskite solar cell (PCS) was prepared (IE-MAI synthesized according to 1-(1)-① as described above was used). For comparison, PSC using the CO-MAI as a base was prepared in the same way. (a) in FIG. 9 shows a structure of the prepared mesoporous PSC (are composed of a FTO substrate as the conductive transparent electrode, a dense TiO$_2$ (c-TiO$_2$) film and a mesoporous TiO$_2$ (mp-TiO$_2$) film as the electron transport layer, a MAPbI$_3$ perovskite film as the photoactive layer, a spiro-MeOTAD film as the hole transport layer, and an Au electrode as a counter electrode). Thicknesses of the FTO, TiO$_2$, MAPbI$_3$, spiro-MeOTAD and Au films are indicated in (b) in FIG. 9 showing a cross-sectional SEM image of PSC, and were 600 nm, 220 nm, 430 nm, 200 nm, and 100 nm, respectively.

For each type of PSC (i.e., IE-PSC vs CO-PSC), 12 PSCs were manufactured. Power conversion efficiencies thereof were measured, recorded and inspected using a current density-voltage (J-V) curve under simulated sunlight (AM 1.5G, 100 mWcm$^{-2}$). (c) in FIG. 9 compares the J-V curves of IE-PSC and CO-PSC with each other. Statistical analysis results of parameters such as short circuit current density (Jsc), open circuit voltage (Voc), charge factor (FF), and power conversion efficiency (PCE) are shown in (d) to (g) in FIG. 9, respectively, and results thereof are summarized in [Table 2] below.

[Table 2]

| Name | | Scan direction | $J_{sc}$ (mA cm$^{-2}$) | $V_{oc}$ (V) | FF | PCE (%) |
|---|---|---|---|---|---|---|
| IE-PSC | Highest | | 21.5 | 1.05 | 0.803 | 18.1 |
| | Average | Reverse direction | 21.0 ± 0.4 | 1.04 ± 0.01 | 0.799 ± 0.005 | 17.5 ± 0.4 |
| | | Forward direction | 20.7 ± 0.4 | 1.02 ± 0.01 | 0.665 ± 0.025 | 14.0 ± 0.7 |
| CO-PSC | Highest | | 21.0 | 1.05 | 0.810 | 17.9 |
| | Average | Reverse direction | 20.7 ± 0.4 | 1.05 ± 0.01 | 0.804 ± 0.007 | 17.5 ± 0.3 |
| | | Forward direction | 20.4 ± 0.4 | 1.03 ± 0.01 | 0.682 ± 0.043 | 14.3 ± 1.0 |

[Table 2]

| Name | | Scan direction | $J_x$ (mA cm$^{-2}$) | $V_{oc}$ (V) | FF (%) | PCE |
|---|---|---|---|---|---|---|
| IE-PSC | Highest | | 21.5 | 1.05 | 0.803 | 18.1 |
| | Average | Reverse direction | 21.0 ± 0.4 | 1.04 ± 0.01 | 0.799 ± 0.005 | 17.5 ± 0.4 |
| | | Forward direction | 20.7 ± 0.4 | 1.02 ± 0.01 | 0.665 ± 0.025 | 14.0 ± 0.7 |
| CO-PSC | Highest | | 21.0 | 1.05 | 0.810 | 17.9 |
| | Average | Reverse direction | 20.7 ± 0.4 | 1.05 ± 0.01 | 0.804 ± 0.007 | 17.5 ± 0.3 |
| | | Forward direction | 20.4 ± 0.4 | 1.04 ± 0.01 | 0.682 ± 0.043 | 14.3 ± 1.0 |

All of the IE-PSCs exhibited excellent diode-type J-V curves with relatively small hysteresis. Jsc of IE-PSC was slightly higher than that of CO-PSC. It is known that photocurrent of PSC mainly depends on light absorption capacity and charge transportability of the perovskite layer. As described above, the absorbance of the IE-MAPbI$_3$ film and the CO-MAPbI3 film are equal to each other. Therefore, the higher Jsc of the IE-PSC film may be due to the improvement of the charge transportability of the IE-MAPbI$_3$ film. The IE-MAPbI$_3$ film has greater crystallinity and a larger particle size than those of the CO-MAPbI$_3$ film. The greater crystallinity and the large particle size may result in a larger charge conversion factor. Further, the larger the crystal size, the lower the density of grain boundaries, thereby result in less charge trapping. Higher diffusion coefficient and longer lifetime may increase a diffusion length ( $L = \sqrt{D\tau}$ , where L is the diffusion length, D is the diffusion coefficient, and $\tau$ is the lifetime). The best solar cell exhibits a fairly high PCE >18%. The average PCE (17.5%) of IE-PSC is equal to that of CO-PSC (17.5%) in the reverse directional scan, and was similar thereto in the forward directional scan with only a 0.3% difference therebetween. Therefore, it may be concluded that the power conversion efficiency of IE-PSC is similar to that of CO-PSC this proves that when a production scale of the ion exchange method for the preparation of the organic halide precursor increases, the LE-PSC is applicable to the perovskite solar cell industry.

**Conclusion**

In accordance with the present disclosure, a simple and environmentally friendly ion exchange method was used as an alternative to the conventional method using HI and HBr for mass production of MAI, MABr, FAI, and FABr. The present method was carried out based on ion exchange between NaI (or NaBr) and MACl (or FACl). NaCl was produced as a by-product. The yield after the separation of each of the four organic halides was in a range of 96 to 100%. When considering the production yield from a thermodynamic point of view, substantially 100% of the reactants are converted into the product in the ion exchange method when MAI is produced. Recrystallizing the prepared MAI may allow the highest purity to be achieved, which is similar to that of a commercially available material.

PSC (IE-PSC) was manufactured using MAI prepared by the ion exchange method according to the present disclosure to examine industrial applicability thereof. The IE-PSC exhibited similar or slightly greater PCE compared to that of a commercial MAI-based solar cell (CO-PSC). A trace of Cl⁻ ions were incorporated into the MAI after the recrystallization. This promoted formation of larger crystals during coating of the perovskite layer, thereby improving the PCE.

The ion exchange method according to the present disclosure for the preparation of the PSC precursor is expected to contribute substantially to the PSC field at an industrially available scale.

Although the present disclosure has been described above with reference to the preferred embodiments of the present disclosure, those skilled in the art may appreciate that various modifications and changes may be made to the present disclosure without departing from the spirit and scope of the present disclosure as set forth in the following claims.

**Claims**

1. A method for preparing an organic halide used for preparing a perovskite, the method comprising: a step (a) of reacting methylammonium chloride or formamidinium chloride with alkali metal iodide or alkali metal bromide.

2. The method of claim 1, wherein the alkali metal iodide is sodium iodide, or the alkali metal bromide is sodium bromide.

3. The method of claim 1, wherein the reaction of the step (a) is an ion exchange reaction carried out in a solvent.

4. The method of claim 1, wherein the reaction of the step (a) is carried out in water or alcohol as a solvent at room temperature or under reflux.

5. The method of claim 1, wherein the method further comprises a step (b) of filtering a product of the reaction of the step (a), and a step (c) of removing the solvent from the product.

6. The method of claim 1, wherein the method further comprises a step (d) of performing recrystallization of a produced organic halide and removing alkali metal chloride therefrom.

7. A perovskite prepared using the organic halide prepared by the method of claim 1 as a precursor.

8. A solar cell comprising:

   a first electrode;
   a second electrode opposite to the first electrode; and
   a photoactive layer disposed at least partially between the first electrode and the second electrode,
   wherein the photoactive layer includes a perovskite prepared using the organic halide prepared by the method
   of claim 1 as a precursor.

9. The solar cell of claim 8, wherein the perovskite is obtained by reacting the organic halide prepared by the method
   of claim 1 and a compound of a chemical formula $MX_2$ with each other,
   wherein X represents an iodide anion or a bromide anion, and M represents a divalent metal cation selected from
   a group consisting of $Pb^{2+}$, $Sn^{2+}$, $Ge^{2+}$, and combinations thereof.

10. The solar cell of claim 8, wherein the solar cell further comprises an electron transport layer and a hole transport
    layer between the first electrode and the second electrode.

FIG. 1A

(a)

FIG. 1B

(b)

FIG. 2

FIG. 3

FIG. 4

FIG. 5

FIG. 6

| Element | Solvent | MAI | MABr | FAI | FABr |
|---------|---------|-----|------|-----|------|
| I | EtOH | 99.17(>99.99)[a] | - | 98.5(>99.99)[a] | - |
| Br | | - | 93.98(>99.99)[a] | - | 95.36(>99.99)[a] |
| Cl | | 0.77 (<LOD)[a] | 5.85(<LOD)[a] | 1.37(<LOD)[a] | 4.64(<LOD)[a] |
| Na | | 0.05(<LOD)[a] | 0.17(<LOD)[a] | 0.13(<LOD)[a] | <LOD(<LOD)[a] |
| I | Water | 98.82 | - | 99.20 | - |
| Br | | - | 95.90 | - | 98.65 |
| Cl | | 1.09 | 4.04 | 0.77 | 1.35 |
| Na | | 0.08 | 0.06 | 0.03 | <LOD |

FIG. 7

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **I. LEVCHUK ; A. OSVET ; X. TANG ; M. BRANDL ; J.D. PEREA ; F. HOEGL ; G.J.MATT ; R. HOCK ; M. BATENTSCHUK ; CJ.BRABEC.** *Nano Lett.,* 2017, vol. 17, 2765-2770